# EUROPEAN PATENT APPLICATION

(11) **EP 0 621 641 A2**
(43) Date of publication of application: **26.10.1994**
(21) Application number: 94105636.8
(22) Date of filing: 12.04.1994
(51) Int. Cl.: H01L 29/73, H01L 21/331

(54) **A heterojunction bipolar transistor and a production method thereof**

(30) Priority: 21.04.1993 JP 93476/93
(71) Applicant: MITSUBISHI DENKI KABUSHIKI KAISHA, Tokyo 100 (JP)
(72) Inventor: Shimura, Teruyuki, c/o Mitsubishi Denki K. K., Itami-shi, Hyogo 664 (JP); Sakai, Masayuki, c/o Mitsubishi Denki K.K., Itami-shi, Hyogo 664 (JP)
(74) Representative: KUHNEN, WACKER & PARTNER

(57) **Abstract**

A heterojunction bipolar transistor includes a collector contact layer (15), a collector layer (14), a base layer (13), and an emitter layer (12) laminated in this order on the front surface of a compound semiconductor substrate (16), a collector electrode (19) disposed on the collector contact layer (15), a base electrode (18) disposed on the base layer (13) , an emitter electrode (17) disposed on the emitter contact layer (11), and an insulating film (21) produced on the collector electrode (19) and the base electrode (18) burying those electrodes with the front surface thereof being flat. The front surface of the emitter electrode (17) positioned uppermost among surfaces of the three electrodes is on the same plane as the flattened front surface of the insulating film and a wiring is directly produced on the emitter electrode. Thus, this HBT has no step difference between etched surfaces, and the wiring is produced by repeating sputtering of Ti/Au and Ar⁺ ion-milling. Therefore, the wiring for the emitter electrode (17) can be formed easily and minutely at high preciseness. In addition, the collector electrode (19) is produced by evaporation and lift-off after required portions of the base layer and the collector layer are removed by dry-etching and a little wet-etching, so that the collector electrode (19) can be produced with generating no burr.

## Description

### FIELD OF THE INVENTION

The present invention relates to a heterojunction bipolar transistor (hereinafter referred to as "HBT"), and a production method thereof and, more particularly, to a technique of flattening an HBT.

### BACKGROUND OF THE INVENTION

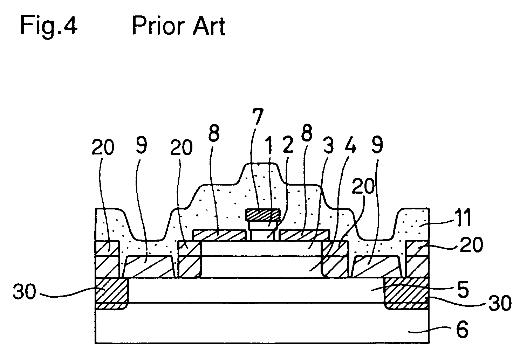

Figure 4 is a cross-sectional view illustrating a prior art AlGaAs/GaAs HBT. In the figure, reference numeral 6 designates a semi-insulating (hereinafter alternatively referred to as "S. I.") GaAs substrate. A collector contact layer 5 is disposed on the semi-insulating GaAs substrate 6. A collector layer 4 is disposed on the collector contact layer 5. A base layer 3 is disposed on the collector layer 4. An emitter layer 2 is disposed on the base layer 3. An emitter contact layer 1 is disposed on the emitter layer 2. A collector electrode 9 is disposed on the collector contact layer 5. A base electrode 8 is disposed on the base layer 3. An emitter electrode 7 is disposed on the emitter layer 2. First insulating regions 20 are produced by first proton bombardment, reaching an interface between the collector contact layer 5 and the collector layer 4. Second insulating regions 30 are produced by second proton bombardment, reaching a portion of the semi-insulating substrate 6. An insulating film 11 is formed on all the above-described layers and electrodes.

The materials of respective layers and respective electrodes, impurity concentrations and thicknesses thereof are as shown in table 1.

**Table 1**

| Layer | Material(s) | Impurity Concentration | Thickness |
|---|---|---|---|
| emitter contact layer 1 | n⁺ In_{0.5}Ga_{0.5}As | 4 x 10¹⁹/cm³ | 1000Å |
| emitter layer 2 | n⁻ Al_{0.3}Ga_{0.7}As | 5 x 10¹⁷/cm³ | 1500Å |
| base Layer 3 | p⁺ GaAs | 4 x 10¹⁹/cm³ | 1000Å |
| collector layer 4 | n⁻GaAs | 5 x 10¹⁶/cm³ | 5000Å |
| collector contact layer 5 | n⁺GaAs | 5 x 10¹⁸/cm³ | 5000Å |
| GaAs substrate 6 | GaAs | | |
| emitter electrode 7 | Ti/Mo/Au | 500/500/5000Å | |
| base electrode 8 | Ti/Mo/Au | 500/500/1000Å | |
| collector electrode 9 | AuGe/Ni/Au | 300/200/3000Å | |
| insulating film 11 | SiO, SiON, SiN | 1000Å Multi-layer is possible. | |

The conditions of the proton bombardment at the production of the insulating regions 20 and 30 by the first and second proton bombardments are as shown in table 2.

**Table 2**

| | | Ion Energy | Dose Quantity |
|---|---|---|---|
| first proton bombardment | | 60 KeV | 1 x 10¹⁵cm⁻² |
| second proton bombardment | prior last | 200 KeV | 3 x 10¹⁵cm⁻² |
| | | 100 KeV | 1 x 10¹⁵cm⁻² |

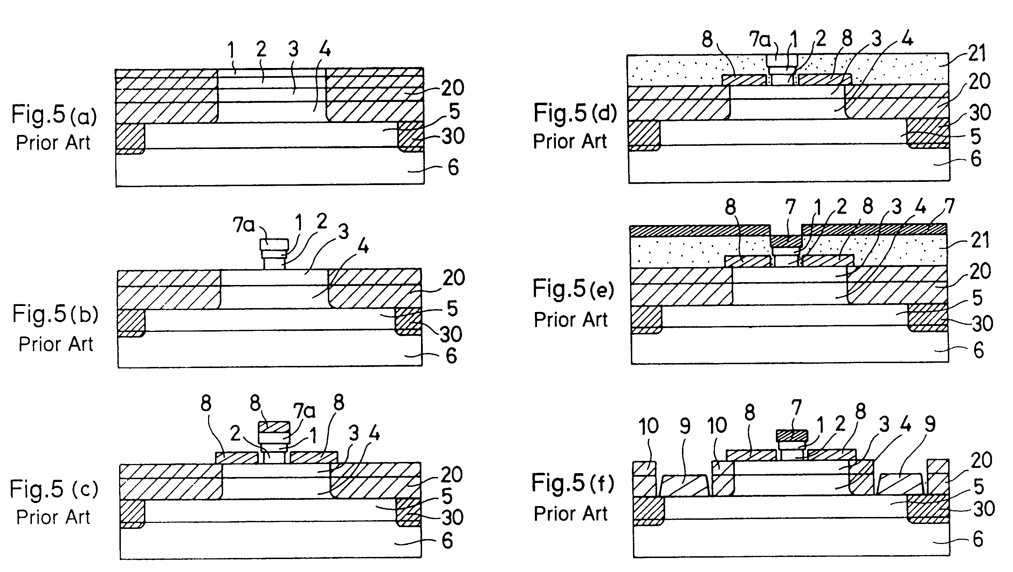

Next, a production method of this prior art HBT will be described with reference to figure 5.

First, a collector contact layer 5, a collector layer 4, a base layer 3, an emitter layer 2, and an emitter contact layer 1 are successively laminated in this order on a semi-insulating substrate 6 by MOCVD (Metal Organic Chemical Vapor Deposition) or MBE (Molecular Beam Epitaxy) as shown in figure 5(a). Then, materials, impurity concentrations, and thicknesses of respective layers are as described above.

Next, first proton bombardment of ion energy of 60 KeV and dose quantity of 1 x 10 ¹⁵cm⁻² is carried out into the epitaxial layers 1, 2, 3, and 4 in regions not contributing to HBT operation, up to reaching the interface between the collector contact layer 5 and the collector layer 4, thereby first insulating regions 20 are produced as shown in figure 5(a), resulting in reduction in the base-collector capacitance. Thereafter, second proton bombardment, comprising two times bombardments, where prior one is of ion energy of 200 KeV and dose quantity of 3 x 10¹⁵cm⁻² and last one is of ion energy of 100 KeV and dose quantity of 1 x 10¹⁵cm⁻², is carried out up to reaching the collector contact layer 5 and a portion of the semi-insulating substrate 6, thereby second insulating regions 30 are produced, resulting in separating between elements as shown in figure 5(a). The distance between the first insulating regions 20 at both sides is 5 µm and the distance between the second insulating regions 30 at both sides is 9 µm.

Next, a dummy emitter electrode 7a is formed in a thickness of 3000 Å by CVD and RIE (Reactive Ion Etching). The n⁺ type InGaAs layer 1 and the n type AlGaAs layer 2 are dry-etched with ECR etcher using the dummy emitter electrode 7a as a mask as shown in figure 5(b).

Next, a base electrode 8 comprising Ti/Mo/Au of 500/500/1000 Å thickness is formed self-aligningly against the dummy emitter electrode 7a on the base layer 3 as shown in figure 5(c).

Next, photoresist 21 is formed on the entire surface, thereafter the photoresist 21 is etched back to carry our head-exposure of the dummy emitter electrode 7a as shown in figure 5(d).

Next, the dummy emitter electrode 7a is removed, and an emitter electrode metal 7 is evaporated on the entire surface as shown in figure 5(e), and thereafter an emitter electrode 7 is formed by lift-off as shown in figure 5(f).

Thereafter, dry-etching with chlorine gas or wet-etching with tartaric acid is carried out to expose the front surface of the collector contact layer 5, and collector electrodes 9 comprising AuGe/Ni/Au of 300/200/5500 Å thickness are formed by evaporation and lift-off as shown in figure 5(f).

Next, SiO or SiO₂ is deposited to form an insulating film 11 using a CVD apparatus, thereby completing a prior art HBT shown in figure 4.

In the HBT produced in the above-described prior art production method, because differences in height (hereinafter referred to as "step differences") are produced between the emitter electrode 7 portion and the base electrode 8 portions and between these electrode portions and the collector electrode 9 portions by performing etching during forming the electrodes, when wirings are produced for drawing out electrode wirings from electrodes for the emitter electrode 7, the base electrodes 8, and the collector electrodes 9, it is difficult to produce the wirings by a combination of sputtering of Ti/Au and Ar⁺ ion-milling, which combination is conventionally employed in producing wirings in GaAs digital ICs.

More particularly, when the step differences are so large, there arises a problem that the sputtered wiring metal enters into concave portions and that the metal in the concave portions positioning in a shade cannot be removed by ion-milling. Furthermore, there is a problem that the metal wiring is broken by the step differences when the step differences are further larger.

Accordingly, such prior art HBT has required a method of providing a bonding pad at the top of electrodes which cross-section is shown in figure 4, for example, at the side beyond the paper surface shown in the figure, and connecting a wiring thereto via an air bridge, or a method of connecting a wiring to a bonding pad through a contact hole in a case where the bonding pad is provided in the insulating film.

As an alternative flattening method, there is a method of flattening the surface of the device by polyimide and providing a contact by forming an aperture in the polyimide. In this method, however, polyimide is difficult to process as well as it is inferior in heat resistance, resulting in low reliability of the device. Besides, handling of polyimide is also complicated.

There is also a method of thermohardening polyimide at approximately 600°C. In this method, however, the polyimide has to be used in an insufficient state because GaAs cannot be heated up to exceeding approximately 300°C.

In the prior art HBT, respective surfaces of the emitter layer, the base layer and the collector layer are exposed by etching, and thereafter electrodes are produced on respective layers, thereby the step differences between the electrodes are likely to become large. Therefore, it is difficult to produce a wiring by a combination of sputtering of Ti/Au and Ar⁺ ion-milling in the prior art HBT, which combination is conventionally employed in producing wirings in GaAs digital ICs. For the above reason, fine pattern wirings required in ICs cannot be formed at high preciseness in the prior art HBT.

### SUMMARY OF THE INVENTION

It is an object of the present invention to provide an HBT in which wirings can be formed easily.

It is another object of the present invention to provide a method of producing such an HBT.

Other objects and advantages of the present invention will become apparent from the detailed description given hereinafter; it should be understood, however, that the detailed description and specific embodiment are given by way of illustration only, since various changes and modifications within the spirit and scope of the invention will become apparent to the those skilled in the art from this detailed description.

According to a first aspect of the present invention, an HBT includes an insulating film having a flat surface formed on collector electrodes and base electrodes burying the collector electrodes and the base electrodes, and the flattened surface of the insulating film is of the same height as the flattened and head-exposed surface of an emitter electrode, etching step differences produced by etching in the HBT are flattened.

In other words, an HBT according to the present invention includes a collector contact layer, a collector layer, a base layer, and an emitter layer which are laminated successively in this order, collector electrodes formed on the collector layer, base electrodes formed on the base layer, and an emitter electrode formed on the emitter layer, and an insulating film having a flat front surface is formed on the collector electrodes and the base electrodes burying these electrodes, and the front surface of the emitter electrode positioned uppermost of the three kinds of electrodes is positioned on the same plane as the flattened insulting film surface, and a wiring is formed directly on the emitter electrode. Therefore, the wiring for the emitter electrode is produced easily and minutely at high preciseness by sputtering and ion-milling which are conventionally employed in producing wirings in GaAs digital ICs.

According to a second aspect of the present invention, an HBT includes a flattened insulating film produced by repeating depositing of an insulating film using an ECR CVD (Electron Cyclotron Resonance Chemical Vapor Deposition) apparatus and sputter-etching of the insulating film with Ar⁺, thereby flattening and head-exposing the emitter electrode. Thus, the flattened insulating film is formed easily.

According to a third aspect of the present invention, an HBT includes the collector electrode which thickness is set equal to or larger than the depth of the etching groove for forming the collector electrode, so that an insulating film which surface is flattened to have the same height as the flattened and head-exposed surface of the emitter electrode, can be formed more easily.

According to a fourth aspect of the present invention, a production method of an HBT includes: laminating a collector contact layer, a collector layer, a base layer, an emitter layer, and an emitter contact layer successively in this order; carrying out first insulating-implantation into the above-described laminated semiconductor layers up to reaching an interface between the collector contact layer and the collector layer to produce first insulating regions; carrying out second insulating-implantation into the laminated semiconductor layers up to reaching the semi-insulating substrate to produce second insulating regions; producing an emitter electrode on the emitter contact layer; etching away the emitter contact layer and the emitter layer to a predetermined depth using the emitter electrode as a mask; depositing an insulating film on the emitter electrode and etching the insulating film to form side walls at both sides of the emitter layer and the emitter electrode; etching away the emitter layer using the side walls as a mask; depositing base metals on the base layer which is exposed by etching of the emitter layer overriding the above of the emitter electrode; applying flattening photoresist on the entire surface of the wafer; etching-back the flattening photoresist remaining only a portion of the base metals on the base layer to form base electrodes; etching away required portions of the insulating implantation base layer and collector layer by dry-etching or wet-etching, and producing collector electrodes on the exposed collector contact layer; and producing the insulating film by repeating deposition of the insulating film using an ECR CVD apparatus and sputtering of the insulating film, thereby carrying out flattening and head-exposing of the emitter electrode. In this way, an HBT including an insulating film which surface is flattened to the same height as the emitter electrode surface, can be easily produced.

According to a fifth aspect of the present invention, in a production method of an HBT, portions of the insulating implantation base layer and collector layer required for producing the collector electrode are removed by dry-etching and further are removed a little by wet-etching, thereby the collector electrodes are produced on the exposed collector contact layer by evaporation and lift-off. Thus, collector electrodes can be produced with generating no burr.

### BRIEF DESCRIPTION OF THE DRAWINGS

Figure 1(a) is a cross-sectional view illustrating an HBT in accordance with an embodiment of the present invention and figure 1(b) is a cross-sectional view illustrating a part of the HBT.

Figures 2(a) to 2(f) are cross-sectional views illustrating process flow for producing the HBT in accordance with the embodiment of the present invention.

Figures 3(a) to 3(c) are cross-sectional views illustrating process steps for producing a collector electrode of the embodiment.

Figure 4 is a cross-sectional view illustrating a prior art HBT.

Figures 5(a) to 5(f) are cross-sectional views illustrating a process flow for producing the prior art HBT.

Figures 6(a) to 6(f) are cross-sectional views illustrating process steps for producing SiO by repeating deposition of SiO and sputter-etching with Ar⁺.

### DETAILED DESCRIPTION OF THE PREFERRED EMBODIMENTS

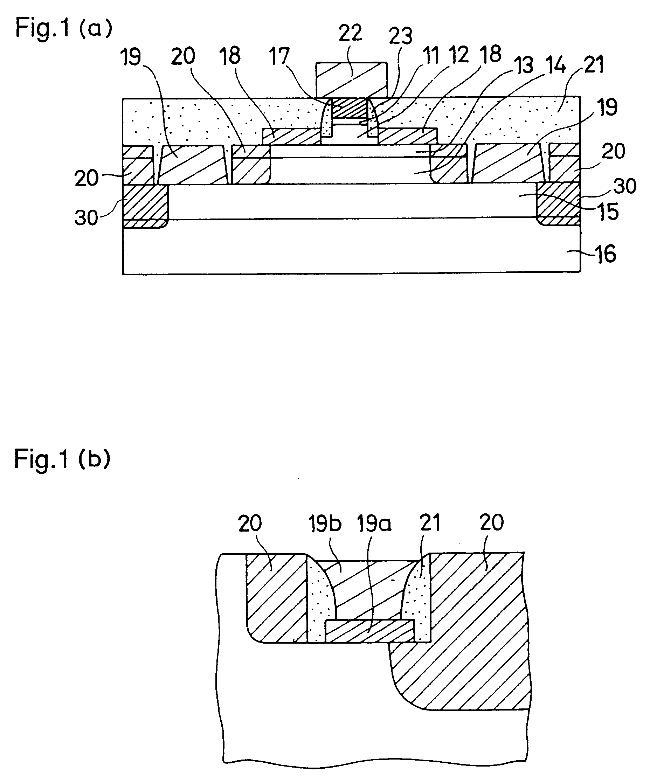

Figure 1 is a cross-sectional view illustrating an HBT semiconductor device in accordance with an embodiment of the present invention.

In the figure, reference numerals 11 to 16 designate the same or corresponding elements as those designated by reference numerals 1 to 6 in figure 4. An emitter electrode 17 is disposed on an emitter contact layer 11. A base electrode 18 is disposed on a base layer 13. A collector electrode 19 is disposed on a collector contact layer 15. A flattening insulating film 21 is formed on all the above-described layers and the electrodes. A wiring 22 is produced on the emitter electrode 17.

The materials of respective semiconductor layers and respective electrodes, impurity concentrations, and thicknesses thereof are as shown in table 3.

**Table 3**

| Layer or Electrode | Material(s) | Thickness |
|---|---|---|
| emitter electrode 17 | WSi | 3000Å |
| base electrode 18 | Ti/Mo/Au | 500/500/1000Å |
| collector electrode 19 | AuGe/Ni/Au | 300/200/5500Å |
| insulating region 20 | formed by proton bombardment | |
| flattening insulating film 21 | SiO | about 5500Å (at the thickest portion) |
| wiring 22 | Ti/Au | 500/5000Å |

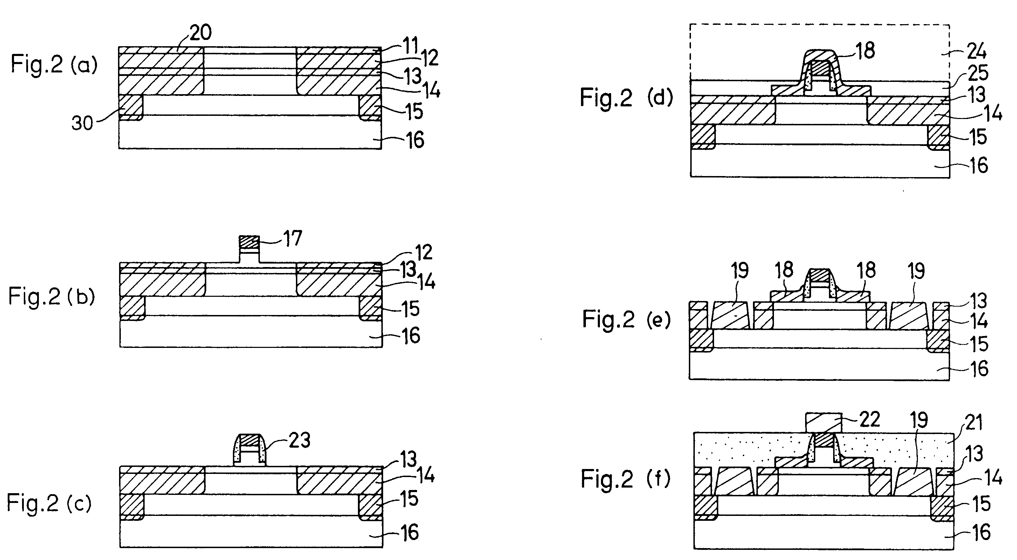

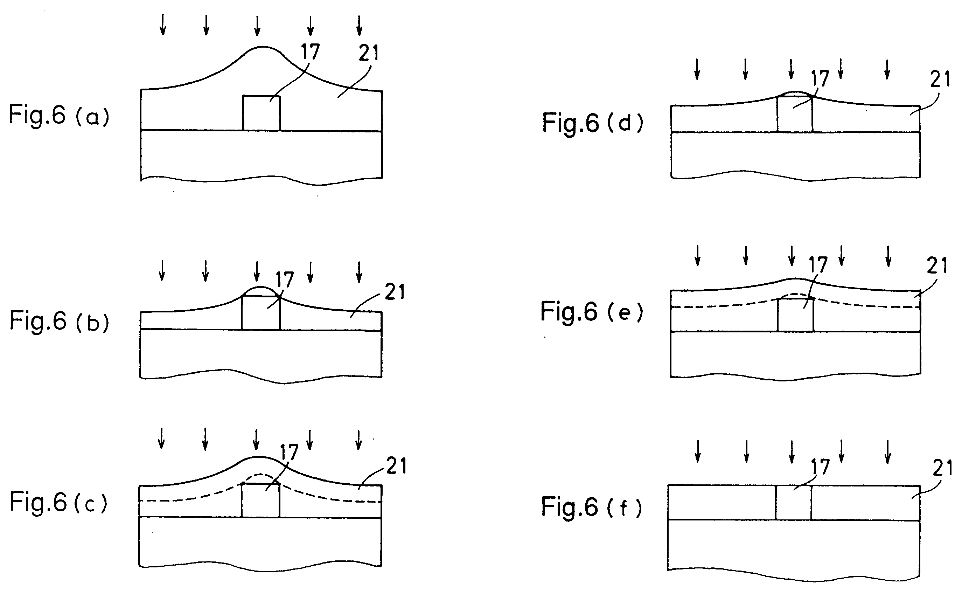

Figures 2(a) to 2(f) are cross-sectional views illustrating a process flow for producing an HBT in accordance with this embodiment. Figure 6 is a cross-sectional view illustrating a process for depositing the SiO.

In the figures, reference numerals 11 to 22 designate the same elements as those in figure 1. Reference numeral 23 designates a side wall comprising SiO of 0.2 µm width. Photoresist 24 of 1 µm thickness is used for flattening before performing etching using O₂ plasma. Photoresist 25 of 2500 Å thickness is used for flattening after performing etching using O₂ plasma.

Next, the production method will be described with reference to figure 2.

First, a collector contact layer 15, a collector layer 14, a base layer 13, an emitter layer 12, and an emitter contact layer 11 are laminated in this order on a semi-insulating substrate 16 by MOCVD (Metal Organic Chemical Vapor Deposition) or MBE (Molecular Beam Epitaxy). The materials, impurity concentrations, and thicknesses of respective layers are as shown in the above table 3.

Next, first proton bombardment of energy of 60 KeV and dose quantity of 1 x 10¹⁵cm⁻² is carried out into portions of the epitaxial layers 11, 12, 13, and 14 which do not contribute to HBT operation to produce first insulating regions 20 as shown in figure 2(a). Thereby, base-collector capacitance can be reduced. Thereafter, second proton bombardment reaching the collector contact layer 15 and the semi-insulating substrate 16, which second bombardment comprises two times bombardments where prior one is of ion energy of 200 KeV and dose quantity of 3 x 10¹⁵cm⁻² and last one is of ion energy of 100 KeV and dose quantity of 1 x 10¹⁵cm⁻², is carried out to produce second insulating regions 30. In the second proton bombardment, although the prior one of ion energy of 200 KeV and dose quantity of 3 x 10¹⁵cm⁻² is of course required, the last one of ion energy of 100 KeV and dose quantity of 1 x 10¹⁵cm⁻² is not necessarily required. However, the additional last proton bombardment contributes to producing the improved insulating regions. By the second proton bombardment, elements can be separated with each other.

Next, an emitter electrode 17 is formed in a thickness of 3000 Å by WSi sputtering and RIE (Reactive Ion Etching) using CF₄ gas. The n⁺ type InGaAs layer 11 and a portion of the n type AlGaAs layer 12 are dry-etched with ECR etcher using the emitter electrode 17 as a mask. The n type AlGaAs layer 12 left by etching, is about 500 Å thick and is completely depleted as shown in figure 2(b).

Next, an SiO film is deposited by plasma CVD, and side walls 23 of 0.2 µm width are formed by RIE with mixed gas of CF₄ gas and oxygen. The remaining portion of the n type AlGaAs layer 12 of 500 Å thickness is dry-etched with chlorine gas using the side walls 23 as a mask to expose the surface of the base layer 13 as shown in figure 2(c).

Next, a base electrode 18 comprising Ti/Mo/Au of 500/500/1000 Å thickness is formed overriding the above of the emitter electrode 17 by evaporation and lift-off as shown in figure 2(d). Flattening photoresist 24 of 1 µm thickness is applied on the entire surface of the wafer. The photoresist 24 is etched with O₂ plasma to make the photoresist 24 thin to about 2500 Å, thereby producing the photoresist 25 as shown in figure 2(d).

Next, a portion of the base electrode 18 above the surface of the photoresist 25 is etched away by Ar⁺ ion-milling, and further the base electrode 18 on the emitter electrode 17 is removed to divide the base electrode 18 as shown in figure 2(e).

Dry-etching or wet-etching is carried out so that the front surface of the collector contact layer 15 is exposed, thereafter collector electrodes 19 comprising AuGe/Ni/Au of 300/200/5500 Å thickness are formed by evaporation and lift-off. Then, in order to perform flattening by an insulating film easily in the next process step shown in figure 2(f), the etching depth and the thickness of the collector electrode 19 are set approximately equal to each other or the collector electrode 19 is formed in the thickness slightly larger than the etching depth as shown in figure 2(e).

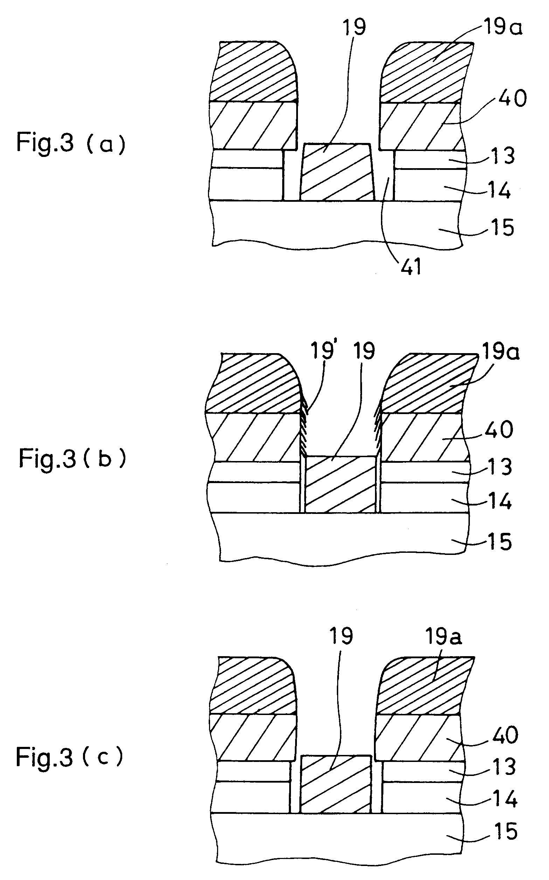

As for the etching for producing the collector electrodes 19, when only wet-etching is carried out at etching the semiconductor layers 13 and 14 using photoresist 40 as a mask as shown in figure 3(a), the amount of the side-etching 41 becomes larger, and thereby wide concave portions are formed at step difference portions between electrodes. In the figure, a collector electrode metal 19a is deposited on the photoresist 40 and removed with the photoresist 40 at lift-off.

On the other hand, when only dry-etching is carried out, the above-described wide concave portions as shown in figure 3(a) are not formed because no side-etching is carried out as shown in figure 3(b), but there remains burr 19' of the collector electrode metal on portions of side surfaces or entire side surfaces of the photoresist 40 and this burr 19' remaining even after the removal of the photoresist 40 may induce electrical defects. Accordingly, when side-etching is carried out a little by wet-etching after the dry-etching so as to remain no burr 19', the collector electrode 19 that induces no such problem as described above can be formed.

Next, deposition of SiO as shown in figures 6(a), 6(c), and 6(e) using an ECR CVD apparatus and Ar⁺ sputter-etching as shown in figures 6(b), 6(d), and 6(f) are repeated, and thereby SiO is produced so as to flatten the surface of the SiO 21 and the position of the SiO 21 surface is adjusted to the position of the emitter electrode 17 surface. Furthermore, Ti/Au of 500/5000 Å thickness are sputtered and Ar⁺ ion-milling is carried out to produce a wiring 22 as shown in figure 2(f).

In the above-described production method of an HBT in accordance with this embodiment, the etching step differences between electrodes, made by etching respective semiconductor layers during producing collector electrodes 19, base electrodes 18, and emitter electrode 17, are flattened by the insulating film 21, which has a front surface on the same plane as that of the emitter electrode 17. Therefore, a wiring for the emitter electrode can be produced in the later process easily and minutely at high preciseness by sputtering and ion-milling which are conventionally employed in producing wirings in GaAs digital ICs. Additionally, deposition of an insulating film using an ECR CVD apparatus and Ar⁺ sputter-etching of the insulating film are repeated to perform flattening and head exposing of the emitter electrode, thereby the flattened insulating film is produced, and the thickness of the collector electrode is set equal to or larger than the depth of the etching groove for producing the collector electrode. Therefore, the insulating film can be produced quite easily.

Furthermore, in order to produce collector electrodes, required portions of the insulating implantation base layer and the collector layer are etched away by dry-etching and wet-etching, thereafter the collector electrode is formed by evaporation and lift-off. Thus, the collector electrode of improved electric characteristics including no burr can be produced.

## Claims

1. A heterojunction bipolar transistor, comprising;
a compound semiconductor substrate having a front surface and a rear surface opposite to said front surface;
a collector contact layer, a collector layer, a base layer, and an emitter layer laminated in this order on the front surface of said semiconductor substrate;
a collector electrode disposed on said collector layer;
a base electrode disposed on said base layer;
an emitter electrode disposed on said emitter layer;
an insulating film produced on said collector electrode and said base electrode burying said electrodes with the front surface thereof being flat;
a front surface of said emitter electrode positioned uppermost among surfaces of said three electrodes, being on the same plane as the flattened front surface of said insulating film; and
a wiring produced directly on said emitter electrode.

2. The heterojunction bipolar transistor of claim 1, wherein said flattening insulating film is produced by repeating deposition of said insulating film using an ECR CVD apparatus and sputter-etching of said insulating film, thereby carrying out flattening and head exposing of said emitter electrode.

3. The heterojunction bipolar transistor of claim 1, wherein the thickness of said collector electrode is equal to or larger than the depth of said etching groove for producing said collector electrode.

4. The heterojunction bipolar transistor of claim 2, wherein the thickness of said collector electrode is equal to or larger than the depth of said etching groove for producing said collector electrode.

5. A method for producing the heterojunction bipolar transistor as defined in claim 1, comprising:
preparing a semi-insulating substrate having a front surface;
forming a collector contact layer, a collector layer, a base layer, an emitter layer, and an emitter contact layer in this order laminatingly on the front surface of said semi-insulating substrate;
producing a first insulating region by carrying out first insulating implantation into said laminatingly disposed semiconductor layers up to reaching the interface between said collector contact layer and said collector layer;
producing a second insulating region by carrying out second insulating implantation into said laminatingly disposed semiconductor layers up to reaching said semi-insulating substrate;
forming an emitter electrode on said emitter contact layer;
etching away said emitter contact layer and said emitter layer up to a predetermined depth using said emitter electrode as a mask ;
producing side walls at both sides of said emitter layer and emitter electrode by depositing an insulating film on said emitter electrode and etching required portions of said insulating film;
etching away said emitter layer using said emitter electrode and said side walls as a mask;
depositing base metal on the base layer exposed by the etching removal of said emitter layer overriding the above of said emitter electrode;
applying flattening photoresist on the entire surface of the wafer;
producing a base electrode by etching back said flattening photoresist remaining only a portion of the base metal on said base layer;
etching away required portions of said base layer and said collector layer to which insulating implantation is carried out, and producing a collector electrode on the exposed collector contact layer; and
producing an insulating film by repeating deposition of an insulating film using an ECR CVD apparatus and Ar⁺ sputter etching of said insulating film, thereby carrying out flattening and head exposing of said emitter electrode.

6. The production method of a heterojunction bipolar transistor as defined in claim 5, wherein the process for producing said collector electrode comprises etching away required portions of said base layer and said collector layer, into which insulating implantation is carried out, by performing dry etching and then performing a little wet etching, and producing said collector electrode by evaporation and lift-off on the collector contact layer exposed by said etching removal.
